# EUROPEAN PATENT APPLICATION

(11) **EP 4 404 712 A1**
(43) Date of publication of application: **24.07.2024**
(21) Application number: 23152921.5
(22) Date of filing: 23.01.2023
(51) Int. Cl.: H10K 30/40, H10K 30/85, H10K 85/50, H10K 85/00

(54) **METHODS OF MANUFACTURING A PEROVSKITE OPTOELECTRONIC DEVICE**

(71) Applicant: CSEM Centre Suisse d'Electronique et de Microtechnique SA - Recherche et Développement, 2002 Neuchâtel (CH)
(72) Inventor: MOON, Soo-Jin, 1421 Fontaines-sur- Grandson (CH); BLONDIAUX, Nicolas, 2206 Les Geneveys-sur-Coffrane (CH); WALTER, Arnaud, 1700 Fribourg (CH); ANDREATTA, Gaëlle, 2000 Neuchâtel (CH); PARACCHINO, Adriana, 2000 Neuchâtel (CH); KAMINO, Brett, 2502 Bienne (CH)
(74) Representative: e-Patent SA

(57) **Abstract**

Method of manufacturing an optoelectronic device (1), comprising the steps of:
- providing a substrate (3);
- depositing a first electrode layer (5) on said substrate (3);
- depositing a first charge-carrier selective layer (7) with a thickness less than 5nm situated directly on said first electrode layer (5);
- depositing insulating silicon oxide nanoparticles (8) directly on said first charge-carrier selective layer (7), said particles having a diameter between 10 nm and 100 nm;
- depositing a perovskite-based semiconductor layer (9) on said first charge-carrier selective layer (7) and on said insulating silicon oxide nanoparticles (8), said perovskite-based semiconductor layer (9) being in intimate contact with both said first charge-carrier selective layer (7) and said insulating silicon oxide nanoparticles (8);
- depositing a second charge-carrier selective layer (11) on said perovskite-based semiconductor layer;
- depositing a second electrode layer (13) on said second charge-carrier selective layer (11).

## Description

### Technical Field

The present invention relates to the field of optoelectronic devices such as photovoltaic devices, LEDs, photodetectors, x-ray detectors etc. More particularly, it relates to methods of manufacture of a perovskite-based optoelectronic device.

### State of the Art

Recently, photovoltaic devices (PV devices) based on so-called perovskite absorber layers have been showing promise as an alternative or complement to conventional crystalline and thin-film silicon-based PV devices, and perovskites have also been used to create light emitting diodes (LEDs), x-ray detectors and photodetectors. "Perovskites" are organometallic halide materials with a formula generically written as ABX₃, where A is an inorganic or organic cation such as Cs, CH₃NH₃ or HC(NH₂)₂, B is a metal such as tin or lead, and X is a halogen anion such as iodine, bromine or chlorine. Examples of such materials are methylammonium lead trihalide (CH₃NH₃PbX₃), Caesium formamidinum lead trihalide (CsH₂NCHNH₂PbX₃), and methylammonium tin triiodide (CH₃NH₃SnI₃). These compounds adopt a similar crystal structure to calcium titanium oxide (CaTiOs) and, when illuminated, generate electron-hole pairs, which can be separated by sandwiching the perovskite absorber layer between an electron transporting n-type layer and a hole-transporting p-type layer, with the perovskite serving as the intrinsic (i) layer so as to form a PIN or NIP stack, analogous to its silicon counterpart. In the case of an LED, the structure is similar, and an injection of current causes the perovskite layer to emit light.

In the case of perovskite-based solar cells, these can be used as single-junction cells, or can be combined with a silicon cell to create a tandem PV device, the perovskite junction being located on the light-incident side of the cell.

The perovskite layer itself is typically deposited in a wet process, such as wet coating followed by evaporation of the carrier solvent, although vapour deposition techniques are also showing promise. An example of room-temperature solution deposition of perovskite is disclosed in Liu & Kelly, "Perovskite solar cells with a planar heterojunction structure prepared using room-temperature solution processing techniques", Nature Photonics 8, 133-138 (2014).

Efficiencies of over 25% have been reported with perovskite single junction solar cells, while perovskite/silicon tandems reach 29% in the literature, such as the 29.8% reported by Tockorn et al, "Nano-optical designs for high-efficiency monolithic perovskite-silicon tandem solar cells", Nature Nanotechnology, 17(11), 1214-1221. https://doi.org/10.1038/s41565-022-01228-8.

Self-assembled monolayers (SAM) and small-molecule organic layers (such as carbon-60) are now increasingly being used as charge-carrier selective layers in perovskite photovoltaic cells and LEDs. The self-assembling properties of SAMs, typically on a transparent conductive oxide (TCO) electrode made of a TCO such as indium tin oxide, (ITO) or another oxide, enable the production of films with a thickness, in theory, down to a single layer of molecules, and thin films of small-molecule organic layers can also be easily produced. Such a thin layer thickness is particularly advantageous for photovoltaic cells as it ensures high optical transparency and a minimal impact on charge-carrier transport across the layer from the perovskite to the electrode, since the electrical resistance of such layers is very low. However, the deposition of a pinhole-free ultrathin (<5 nm) film on large surfaces (>1 cm²) has remained a challenge. Certain regions of the electrode layer are often not fully covered by the molecules, leading to direct contacts between the perovskite absorber and the electrode. Due to the lack of charge-carrier selectivity of the electrode/perovskite interface, nanometric-scale shunts form in these regions, which reduces the overall performance of the device.

Typical solutions involve depositing the charge-carrier selective layer as a bilayer, with e.g. a layer of TiO₂ or NiOₓ being provided between the ultrathin layer (here the SAM layer) and the electrode to eliminate contact between the electrode and the perovskite. The increased thickness of the charge-carrier selective layer bilayer compared to the ultrathin helps to reduce the number of shunts. However, this places extra material (>5 nm of TiO₂ or NiOₓ) and extra material interfaces in the light path, and increases the resistance to the movement of charges between the perovskite layer and the electrode. As a result, the efficiency of such a cell is not optimal.

The aim of the present invention is hence to at least partially overcome the above-mentioned deficiencies of the prior art.

### Disclosure of the Invention

More precisely, the invention relates to a method of manufacturing an optoelectronic device such as a solar cell, photodetector, x-ray detector or a LED, comprising the steps of:
- providing a substrate, e.g. a glass, plastic, or metal plate, a crystalline silicon solar cell or similar;
- depositing a first electrode layer on said substrate, this first electrode layer typically being a transparent conductive oxide (TCO);
- depositing a first charge-carrier selective layer, with a thickness of less than 5 nm, situated directly on said first electrode layer, that is to say a self-assembled monolayer (SAM) or small-molecule organic layer (such as C60 or phenyl-C61-butyric acid methyl ester) without another charge-carrier selective layer adjacent to it;
- depositing insulating silicon oxide nanoparticles directly on the first charge-carrier selective layer, said particles having an average diameter between 10 nm and 100 nm;
- depositing a perovskite-based semiconductor layer directly on said first charge-carrier selective layer and on said insulating silicon oxide nanoparticles, such that the perovskite layer is in intimate contact with both the sub-5 nm charge-carrier selective layer and the nanoparticles deposited thereupon;
- depositing a second charge-carrier selective layer on said perovskite-based semiconductor layer, where this second charge-carrier selective layer could also be a sub-5 nm layer such as a layer of small-molecule organic materials (e.g. C60 or phenyl-C61-butyric acid methyl ester) or could also be a SAM layer, however this does not have to be the case and it could be a conventional, thicker layer of any suitable material;
- depositing a second electrode layer on said second charge-carrier selective layer, this layer typically being a bilayer of SnOₓ/TCO or a metal layer.

It should be noted that in a typical p-i-n configuration, the first charge-carrier selective layer would be a SAM and the second charge-carrier selective layer would be a C60 or phenyl-C61-butyric acid methyl ester layer. This statement applies equally to all embodiments described below.

As a result, the insulating nanoparticles have the tendency to fill in any pinholes in the sub-5 nm first charge-carrier selective layer, preventing shunts without recourse to a further charge-carrier transport layer, thereby decreasing the internal resistance of the optoelectronic device, decreasing optical losses, and improving its efficiency.

Advantageously, said second charge-carrier selective layer also has a thickness less than 5nm, and the method further comprises a step of depositing insulating silicon oxide nanoparticles directly on said second charge-carrier selective layer before depositing said second electrode layer on said second charge-carrier selective layer and said nanoparticles, such that the second electrode layer is in intimate contact with said second charge-carrier selective layer and said nanoparticles deposited thereupon.

This brings the same advantages in respect of the second charge-carrier selective layer - second electrode layer interface.

Advantageously, said second charge-carrier selective layer also has a thickness less than 5nm, and the method further comprises a step of depositing insulating silicon oxide nanoparticles directly on said perovskite-based semiconductor layer before depositing said second charge-carrier selective layer on said perovskite-based semiconductor layer and said nanoparticles, such that said second charge-carrier selective layer is in intimate contact with said perovskite-based semiconductor layer and said nanoparticles.

This brings the same advantages in respect of the perovskite - second charge-carrier selective layer interface.

The invention also relates to a method of manufacturing an optoelectronic device which differs from that described above in that the insulating silicon oxide nanoparticles are deposited on the second charge-carrier selective layer rather than on the first, the second charge-carrier selective layer having a thickness less than 5nm (such as a SAM or a or a small-molecule organic material layer), with the second electrode layer situated upon and in intimate contact with said second charge-carrier selective layer and said insulating silicon oxide nanoparticles deposited thereupon.

This brings the same advantages in respect of the interface between the second charge-carrier selective layer and the second electrode layer.

Furthermore, the invention likewise relates to a method of manufacturing an optoelectronic device which differs from that described first above in that the insulating silicon oxide nanoparticles are deposited on perovskite-based semiconductor layer rather than on the first charge-carrier selective layer, and the second charge-carrier selective layer, which has a thickness less than 5nm (e.g. consisting of a small-molecule organic layer or a self-assembled monolayer), is deposited upon and in intimate contact with said perovskite layer and said insulating silicon oxide nanoparticles deposited thereupon.

This likewise brings the same advantages in respect of the interface between the perovskite layer and the second charge-carrier selective layer.

Furthermore, the invention likewise relates to a method of manufacturing an optoelectronic device which differs from that described first above in that the insulating silicon oxide nanoparticles are deposited on the first electrode layer before depositing the first charge-carrier selective layer with a thickness of less than 5nm thereupon, in intimate contact with the first electrode layer and the nanoparticles deposited thereupon.

Again, this brings the same advantages to the first electrode layer - first charge-carrier selective layer interface.

Advantageously, at least one said first charge-carrier selective layer and said second charge-carrier selective layer consists of a SAM or a small-molecule organic material. This keeps the internal resistance of the device to a minimum.

Advantageously, whichever charge carrier selective layer which has a thickness of less than 5nm is in direct contact with both said perovskite-based semiconductor layer and an adjacent electrode layer. This applies to both charge-carrier selective layers if each of them is less than 5 nm (and hence a SAM or small organic molecule layer), and signifies that no extra charge-carrier selective layers are present in contact with a sub-5 nm charge-carrier selective layer.

Advantageously, said insulating silicon oxide nanoparticles have an average diameter of 20-30 nm.

Advantageously, said first charge-carrier selective layer is a hole transport layer (such as Me-4PACz, [4-(3,6-Dimethyl-9H-carbazol-9-yl)butyl]phosphonic acid) and said second charge-carrier selective layer is an electron transport layer such as C60 (carbon-60) or phenyl-C61-butyric acid methyl ester.

Advantageously, said insulating silicon oxide nanoparticles cover between 10% and 70% of the surface upon which they are deposited, preferably between 40% and 60% thereof.

The invention also relates to the use of insulating nanoparticles, such as silicon oxide, aluminium oxide or others, to prevent electrical shunts in a perovskite-based optoelectronic device comprising a charge-carrier selective layer less than 5 nm thick in direct contact with an electrode layer, said insulating nanoparticles having an average diameter between 10 nm and 100 nm and being situated on one or both of:
- an interface between a sub-5nm thick charge-carrier selective layer and a perovskite layer;
- an interface between a sub-5nm thick charge-carrier selective layer and an electrode layer.

The invention also relates to a method of preventing electrical shunts in a perovskite-based optoelectronic device comprising a charge-carrier selective layer with a thickness of less than 5 nm in direct contact with an electrode layer, said method comprising a step of depositing insulating nanoparticles, such as silicon oxide, aluminium oxide or other, having an average diameter between 10 nm and 100 nm on one or more of:
- a charge-carrier selective layer with a thickness less than 5 nm upon which a perovskite layer is subsequently deposited;
- a perovskite layer upon which a charge-carrier selective layer with a thickness less than 5 nm is subsequently deposited;
- a charge-carrier selective layer with a thickness less than 5 nm upon which an electrode layer is subsequently deposited;
- an electrode layer upon which a charge-carrier selective layer with a thickness less than 5 nm is subsequently deposited.

This use and this method present the same advantages as described above.

### Brief description of the Drawings

Further details of the invention will become more apparent upon reading the following description, in reference to the appended figures in which:
- Figure 1 is a schematic cross-sectional view of a first variant of an optoelectronic device according to the invention;
- Figure 2 is a schematic cross-sectional view of a second variant of an optoelectronic device according to the invention;
- Figure 3 is a schematic cross-sectional view of a third variant of an optoelectronic device according to the invention;
- Figure 4 is a schematic cross-sectional view of a fourth variant of an optoelectronic device according to the invention;
- Figure 5 is a schematic cross-sectional view of a fifth variant of an optoelectronic device according to the invention;
- Figure 6 is a scanning electron micrograph of nanoparticles on a SAM layer as used in any of the variants of figures 1-5;
- Figure 7 is a schematic cross-sectional view of a sixth variant of an optoelectronic device according to the invention; and
- Figure 8 is a schematic cross-sectional view of a seventh variant of an optoelectronic device according to the invention.

### Embodiments of the Invention

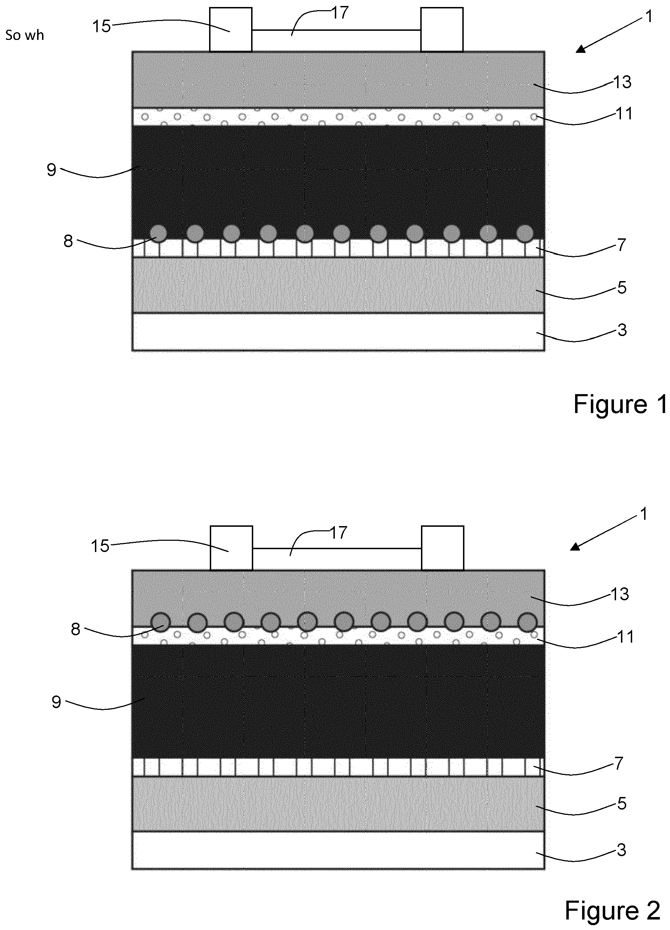

Figure 1 schematically illustrates an optoelectronic device 1, namely a solar cell (i.e. a photovoltaic cell) produced by the method of the invention. In the foregoing, the example of a solar cell 1 is used, however perovskite-based LEDs, photodetectors, x-ray detectors and other optoelectronic devices have a similar structure and the principle of the invention can equally be applied thereto, *mutatis mutandis.* It should be noted that the figures are not to scale.

Returning to the solar cell 1 illustrated in figure 1, this can be a single junction perovskite cell, in which case substrate 3 is an opaque or transparent support layer such as glass, polymer foil or metal, or a tandem cell, in which substrate 3 is a bottom cell such as (but not limited to) a conventional silicon cell such as a crystalline silicon cell. The upper surface of the substrate 3 may be textured, as is generally known and which will be discussed further below.

In the foregoing, it should be noted that unless otherwise stated explicitly, each layer can be directly deposited on the previously-formed layer, or may be indirectly deposited thereupon with an intervening layer in between, and the method proceeds from bottom to top in the orientation of figures 1-5, 7 and 8.

Upon the substrate 3, the cell 1 comprises a first electrode layer 5, typically made of a transparent conductive oxide (TCO) such as indium tin oxide (ITO), zinc oxide, indium zinc oxide (IZO) or similar. First electrode layer 5 may be doped or undoped. This is typically deposited by magnetron sputtering to a thickness of between 10 nm and 500 nm, preferably on the order of 150 nm for single junctions and 10-20 nm for tandems. In the case of zinc oxide, this may be up to 2000 nm.

Upon the first transparent conductive oxide layer 5, a first charge-carrier selective layer 7 is deposited directly, without an intervening layer. This is either a hole transport (p-type) or an electron transport (n-type) layer, of an applicable type as is generally known in the field of perovskite photovoltaic cells. First charge-carrier selective layer 7 has a thickness less than 5 nm, and e.g. consists of a single layer of self-assembled monolayer (SAM), typically of e.g. a carbazole functional group with phosphonic acid anchor group (Me-4PACz, MeO-2PACz, 2PACz) or other substance such as a triphenylamine functional group with carboxylic acid or those mentioned in Al-Ashouri, A.; Köhnen, E.; Li, B.; Magomedov, A.; Hempel, H.; Caprioglio, P.; Márquez, J. A.; Morales Vilches, A. B.; Kasparavicius, E.; Smith, J. A.; Phung, N.; Menzel, D.; Grischek, M.; Kegelmann, L.; Skroblin, D.; Gollwitzer, C.; Malinauskas, T.; Jośt, M.; Matić, G.; Rech, B.; Schlatmann, R.; Topić, M.; Korte, L.; Abate, A.; Stannowski, B.; Neher, D.; Stolterfoht, M.; Unold, T.; Getautis, V.; Albrecht, S. Monolithic Perovskite/Silicon Tandem Solar Cell with >29% Efficiency by Enhanced Hole Extraction. Science (80). 2020, 370 (6522), 1300-1309. https://doi.org/10.1126/science.abd4016, without an extra charge-carrier selective layer (e.g. of TiO₂ or NiOₓ) in contact therewith. Alternatively, the sub-5nm thickness first charge-carrier selective layer 7 can be a small-molecule organic material such as carbon 60 or phenyl-C61-butyric acid methyl ester, notably if this layer is an n-type layer. The first charge-carrier selective layer 7 can be deposited by spin coating, spray coating, blade coating, slot-die coating, immersion, inkjet printing or other. An annealing step may be carried out to anchor the layer 7 to the underlying electrode layer 5, e.g. at 100°C for 5-15 minutes, and excess molecules which are not bound to the underlying layer 5 can be washed away in a gentle solvent such as ethanol or isopropanol.

The key to the invention relates to insulating nanoparticles 8, in particular insulating silicon dioxide (SiO₂) nanoparticles, which are deposited on the underlying layer (i.e. the sub-5 nm layer 7 in the case of figure 1) from a nanoparticle colloidal solution using spin coating, spray coating, blade-coating, slot-die coating, inkjet printing, or similar. A low-temperature annealing step may be used to remove the solvent (typically an alcohol) used to disperse the nanoparticles. These will be described further once the remainder of the layer stack has been explained.

Directly upon the first charge-carrier selective layer 7 and the nanoparticles 8 is deposited a perovskite-based semiconductor layer 9 (which can be abbreviated to "perovskite layer 9" in the context of the present specification, and which is an absorber layer in the case in which the device 1 is a solar cell, photodetector, x-ray detector or similar, and is an emitter layer in the case in which the device 1 emits radiation such as light), typically based on perovskite materials with the generic formulae (Cs,FA,MA)Pb(I,Br,Cl)₃ or (Cs,FA)Pb(I,Br,Cl)₃. Other types of perovskite material are however possible. Many different perovskite deposition processes are known in the literature, and are typically either a standard one-step solution or vapour deposition process, or a two-step process such as that described in F. Sahli, J. Werner, B. A. Kamino, M. Bräuninger, R. Monnard, B. Paviet-Salomon, L. Barraud, L. Ding, J. J. Diaz Leon, D. Sacchetto, G. Cattaneo, M. Despeisse, M. Boccard, S. Nicolay, Q. Jeangros, B. Niesen, C. Ballif, "Fully textured monolithic perovskite/silicon tandem solar cells with 25.2% power conversion efficiency", Nat. Mater. 17, 820-826 (2018), hereby incorporated by reference in its entirety. This two-step process involves a first step of co-evaporating a CsBr/PbI₂ template on the underlying layer, namely the first charge transport layer 7 and the nanoparticles 8, and then solution-depositing a perovskite precursor so as to form the perovskite layer 9.

Upon the perovskite layer 9 is deposited a charge-carrier selective layer 11, of the opposite type to the first charge transport layer 7 (i.e. if layer 7 is p-type, layer 11 is n-type and vice-versa). This is typically an electron transport layer (ETL) based on carbon-60, although other types of charge transport layers based on SAMs or other substances are possible, as is generally known. As a general rule in the context of the present invention, any charge-carrier selective layer 7, 11 which is in contact with nanoparticles 8 will be a thin layer with a thickness of less than 5nm, whereas a charge-carrier selective layer 7, 11 not in contact with nanoparticles 8 can either also be a sub-5nm thick layer of SAM or small-molecule organic material, or any other convenient type of any convenient thickness.

Upon second charge-carrier selective layer 11 is deposited a second electrode layer 13, typically again of TCO, which may be a single layer or a multilayer of two different materials, such as one or more of doped or undoped tin oxide, indium tin oxide, indium zinc oxide or similar. A non-illustrated buffer layer of e.g. atomic layer deposited SnO₂ may also be deposited between the second charge-carrier selective layer 11 and the second electrode layer 13. Upon this layer may be deposited a patterned metallic contact layer 15 which may consist in screen-printed silver paste, vapour-deposited copper or silver, or similar, and is typically patterned, as is known. One or more further layers 17, such as anti-reflection layers, can also be deposited on top of the second electrode layer 13 in the interstices between patterned metallic contacts.

However, these examples of materials for the various layers are not to be held as limiting, and the full panoply of suitable materials can be used, as is generally known in the art, provided that the processing temperatures of the layers 11, 13 deposited after the perovskite layer 9 do not negatively influence this latter.

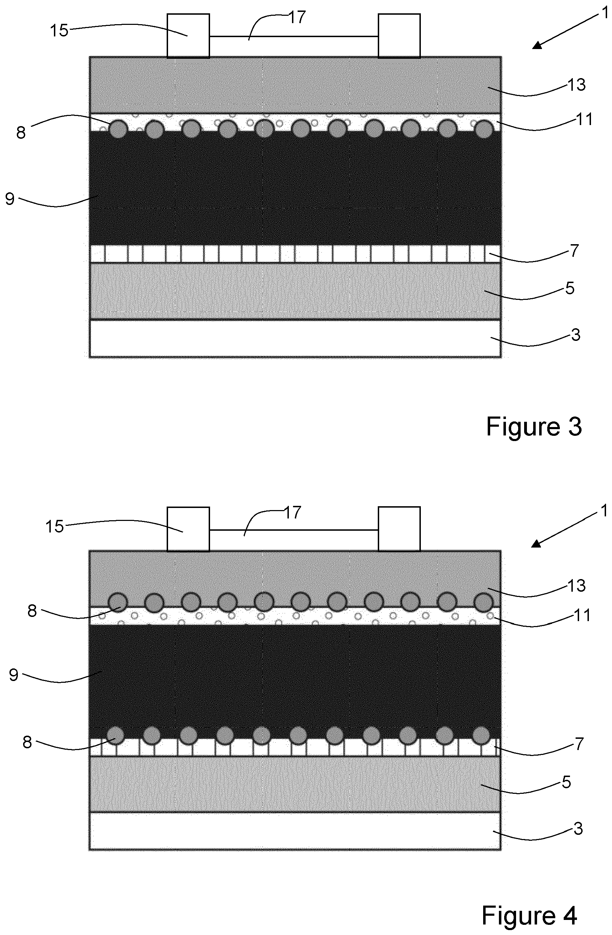

The solar cell 1 of figure 2 differs from that of figure 1 in that the nanoparticles 8 are deposited on top of the second charge-carrier selective layer 11, which is a SAM layer or thin (< 5nm) layer of organic material, and the second electrode layer 13 is directly deposited on the second charge-carrier selective layer 11 and the nanoparticles 13. In figure 3, the nanoparticles 8 are deposited on the perovskite layer 9, and the second charge-carrier selective layer 11 is deposited directly on the perovskite layer 9 and the nanoparticles 8.

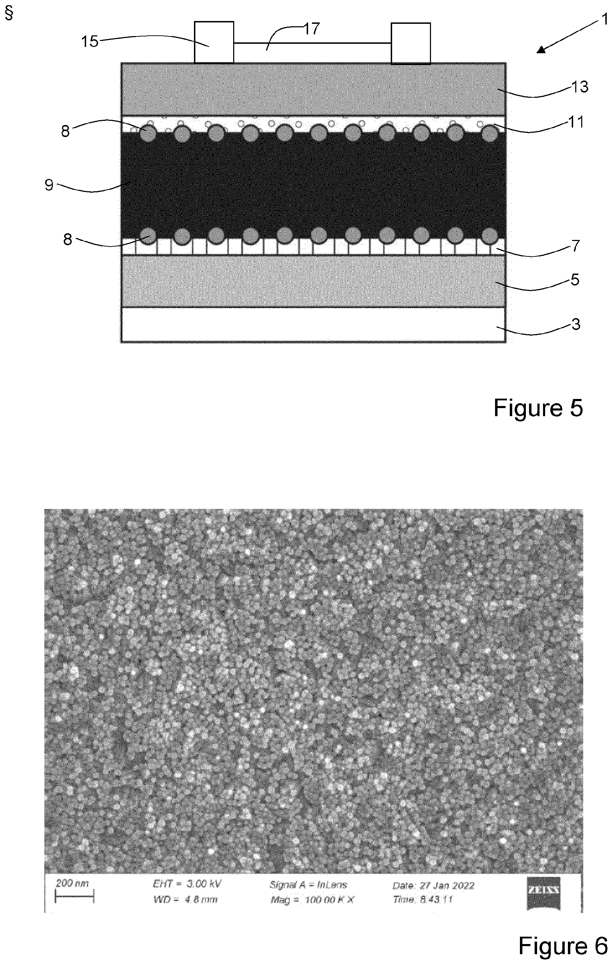

In figure 4, two sets of nanoparticles 8 are deposited, a first on the first charge-carrier selective layer 7 (as in figure 1) and the second on the second charge-carrier selective layer 11 (as in figure 2). Finally, in figure 5, again, two sets of nanoparticles 8 are deposited, a first on the first charge-carrier selective layer 7 (as in figure 1) and the second on the perovskite layer 9 (as in figure 3).

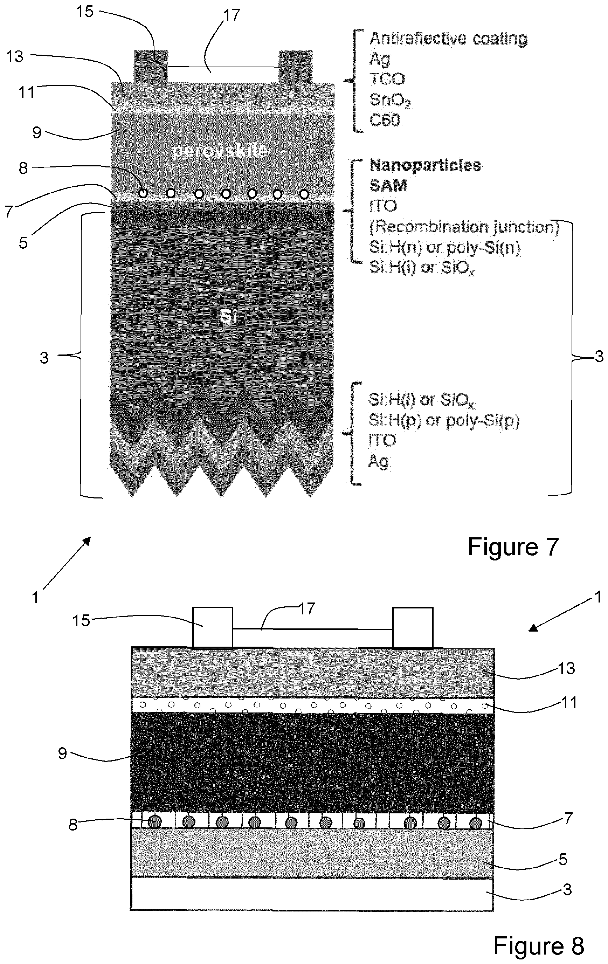

In figure 8, the nanoparticles 8 are deposed on the first electrode layer 5, and the first charge-carrier selective layer 7 is deposited thereupon, in intimate contact with both the nanoparticles 8 and the first electrode layer 5.

To return to the subject of the nanoparticles 8, during the drying phase of the coating, these nanoparticles 8 have the tendency to settle in and fill any holes or dips present in the layer upon which they are deposited, that is to say in the context of figures 1, 4 and 5 the sub-5nm first charge-carrier selective layer 7, in figures 2 and 4 the sub-5nm second charge-carrier selective layer 11, in figures 3 and 5 the perovskite layer 9, and in figure 7 on the first electrode layer 5. These nanoparticles have an average diameter between 10 and 100 nm, more particularly substantially 20-30 nm, and in all cases help to prevent direct contact between the perovskite layer 9 and the electrode layer 5 and/or 13, as appropriate, due to defects in the various layers. It should be noted that the representations of nanoparticles 8 in figures 1-5, 7 and 8 are schematic, and are in fact of larger diameter than the charge-carrier transport layer 7, 11 with which they are in contact.

Particularly in the case when the nanoparticles 8 are deposited on a SAM or small-molecule organic sub-5nm charge-carrier selective layer 7 and/or 11 (as appropriate), this layer may have through-going pinholes, into which the particles will tend to settle mainly due to surface tension which leads to a pinning of the triple line on the defects of the sub-5nm layer and thereby prevent electrical shunts (that is to say short circuits through the charge-carrier selective layer 7, 9 between the adjacent electrode 5, 13 and the perovskite layer 9), while incidentally improving wettability in the case in which the next layer is deposited by a solution-based process. In the case of the nanoparticles 7 being provided on the perovskite layer 9 (cf. figures 3 and 5) or first electrode layer 5 (figure 8), they will tend to adhere to surface irregularities such as valleys, holes, protrusions etc. on the layer 5, 9 (as appropriate) and since they are larger than the thickness of the sub-5nm charge-transport layer, they thereby insulate these defects which reduces shunts and hence reduces non-radiative recombination that otherwise would be present at the perovskite/charge-carrier transport layer interface. Incidentally, the hydrophilic property of the nanoparticles improves the wettability of the surface for the deposition of the SAM via a solution process. These shunts are prevented without needing recourse to a thicker, extra charge-carrier selective layer, reducing the obstruction of the optical pathway and minimizing the internal resistance of the cell 1, thereby maximizing the efficiency and open circuit voltage of the cell 1.

Since SiO₂ is colourless, the nanoparticles do not introduce parasitic absorption of light. The nanoparticle colloidal solution concentration and deposition conditions can be adjusted such as to provide a partial coverage, leaving some SAM-coated surface exposed (>10% of surface exposed, typically about 50%, see Figure 6). Also, in certain circumstances aluminium oxide or other types of insulating nanoparticles can also be used.

Since the charge-carrier selective layer 7 and/or 11 associated with the nanoparticles 8, and ideally both of the charge-carrier selective layers 7, 11, are monolayers made from SAMs or small-molecule organic materials such as C60 or phenyl-C61-butyric acid methyl ester, without any adjacent extra charge-carrier selective layers or other layers deposited to prevent shunts, the thickness of the non-perovskite layers can be kept at a minimum, increasing the efficiency, reducing the internal resistance and maximizing the open circuit voltage, fill factor and photocurrent of the cell 1, and minimizing the number of processing steps.

Figure 7 illustrates a tandem cell 1 according to the invention, which has achieved an efficiency of 30.9% on 1 cm² surface area, and 29.5% on 25 cm², two records for these device dimensions.

Substrate 3 is a crystalline silicon cell formed by a layer stack of, starting from the back side, Ag contacts, ITO electrode layer, Si:H(p) or poly-Si(p) charge-carrier selective layer, Si:H(i) or SiOx passivation layer, intrinsic Si wafer, Si:H(i) or SiOx passivation layer, Si:H(n) or poly-Si(n) charge-carrier selective layer.

First electrode layer 5 is of ITO, first charge-carrier selective layer 7 is of Me-4PACz ([4-(3,6-Dimethyl-9H-carbazol-9-yl)butyl]phosphonic Acid) SAM, nanoparticles 8, deposited on first charge-carrier selective layer 7 were SiO₂ with a size of 20-30 nm and surface coverage of 50 %, perovskite layer 9 is of Cs_{0.05}((H₂NCHNH₂)_{0.83}(CH₃NH₃)_{0.17})_{0.95}Pb(I_{0.83}Br_{0.17})₃, second charge-carrier selective layer 11 is C60, second electrode layer 13 is a bilayer of TCO on SnO₂, and then printed silver contacts 15 and an anti-reflective layer 17 were furthermore provided.

Although the invention has been described in terms of specific embodiments, variations thereto are possible without departing from the scope of the invention as defined by the appended claims.

## Claims

1. Method of manufacturing an optoelectronic device (1), comprising the steps of:
- providing a substrate (3);
- depositing a first electrode layer (5) on said substrate (3);
- depositing a first charge-carrier selective layer (7) with a thickness less than 5nm situated directly on said first electrode layer (5);
- depositing insulating silicon oxide nanoparticles (8) directly on said first charge-carrier selective layer (7), said particles having an average diameter between 10 nm and 100 nm;
- depositing a perovskite-based semiconductor layer (9) on said first charge-carrier selective layer (7) and on said insulating silicon oxide nanoparticles (8), said perovskite-based semiconductor layer (9) being in intimate contact with both said first charge-carrier selective layer (7) and said insulating silicon oxide nanoparticles (8);
- depositing a second charge-carrier selective layer (11) on said perovskite-based semiconductor layer;
- depositing a second electrode layer (13) on said second charge-carrier selective layer (11).

2. Method according to claim 1, wherein said second charge-carrier selective layer (11) has a thickness less than 5nm and wherein said method further comprises a step of depositing insulating silicon oxide nanoparticles (8) directly on said second charge-carrier selective layer (11) before depositing said second electrode layer (13) on said second charge-carrier selective layer (11) and said nanoparticles (8), said second electrode layer (13) being in intimate contact with said nanoparticles (8) and said second charge-carrier selective layer (11).

3. Method according to claim 1, wherein said second charge-carrier selective layer (11) has a thickness less than 5nm and wherein said method further comprises a step of depositing insulating silicon oxide nanoparticles (8) directly on said perovskite-based semiconductor layer (9) before depositing said second charge-carrier selective layer (11) on said perovskite-based semiconductor layer (9) and on said nanoparticles (8), said second charge-carrier selective layer (11) being in intimate contact with said perovskite-based semiconductor layer (9) and said nanoparticles (8).

4. Method of manufacturing an optoelectronic device (1), comprising steps of:
- providing a substrate (3)
- depositing a first electrode layer (5) on said substrate (3);
- depositing a first charge-carrier selective layer-carrier selective layer (7) on said first electrode layer (5);
- depositing a perovskite-based semiconductor layer (9) on said first charge-carrier selective layer (7);
- depositing a second charge-carrier selective layer (11) with a thickness less than 5nm on said perovskite layer (9);
- depositing insulating silicon oxide nanoparticles (8) directly on said second charge-carrier selective layer (11), said particles having an average diameter between 10 nm and 100 nm;
- depositing a second electrode layer (13) directly on said second charge-carrier selective layer (11) and on said nanoparticles (8), said second electrode layer (13) being in intimate contact with said second charge-carrier selective layer (11) and said nanoparticles (8).

5. Method of manufacturing an optoelectronic device (1), comprising steps of:
- providing a substrate (3);
- depositing a first electrode layer (5) on said substrate (3);
- depositing a first charge-carrier selective layer (7) on said first electrode layer (5);
- depositing a perovskite-based semiconductor layer (9) on said first charge-carrier selective layer (7);
- depositing insulating silicon oxide nanoparticles (8) directly on said perovskite-based semiconductor layer (9), said particles having an average diameter between 10 nm and 100 nm;
- depositing a second charge-carrier selective layer (11) with a thickness less than 5nm on said perovskite layer (9) and on said insulating silicon oxide nanoparticles (8), said second charge-carrier selective layer (11) being in intimate contact with said perovskite layer (9) and said insulating silicon oxide nanoparticles (8);
- depositing a second electrode layer (13) directly on said second charge-carrier selective layer (11).

6. Method of manufacturing an optoelectronic device (1), comprising steps of:
- providing a substrate (3);
- depositing a first electrode layer (5) on said substrate (3);
- depositing insulating silicon oxide nanoparticles (8) directly on said first electrode layer (5), said particles having an average diameter between 10 nm and 100 nm;
- depositing a first charge-carrier selective layer (7) with a thickness less than 5nm on said first electrode layer (5) and on said insulating silicon oxide nanoparticles (8), said first charge-carrier selective layer (7) being in intimate contact with said first electrode layer (5) and said insulating silicon oxide nanoparticles (8);
- depositing a perovskite-based semiconductor layer (9) on said first charge-carrier selective layer (7);
- depositing a second charge-carrier selective layer (11) on said perovskite layer (9);
- depositing a second electrode layer (13) on said second charge-carrier selective layer (11).

7. Method according to any preceding claim, wherein at least one of said first charge-carrier selective layer (7) and said second charge-carrier selective layer (11) consists of a self-assembled monolayer or an organic material such as a fullerene.

8. Method according to any preceding claim, wherein said charge carrier selective layer with a thickness less than 5nm (7; 11) is in direct contact with both said perovskite-based semiconductor layer (9) and an adjacent electrode layer (5; 13).

9. Method according to any preceding claim, wherein said insulating silicon oxide nanoparticles (8) have an average diameter of 20-30 nm.

10. Method according to any preceding claim, wherein said first charge-carrier selective layer (7) is a hole transport layer, and said second charge-carrier selective layer (11) is an electron transport layer.

11. Method according to any preceding claim, wherein said insulating silicon oxide nanoparticles (8) cover between 10% and 70% of the surface upon which they are deposited, preferably between 40% and 60% thereof.

12. Method according to any preceding claim, wherein said optoelectronic device (1) is a solar cell.

13. Use of insulating nanoparticles (8) to prevent electrical shunts in a perovskite-based optoelectronic device (1) comprising at least one charge-carrier selective layer with a thickness less than 5nm (7; 11) in direct contact with an electrode layer (5; 13), said insulating nanoparticles (8) having a diameter between 10 nm and 100 nm and being situated on at least one of:
- an interface between a charge-carrier selective layer with a thickness less than 5nm (7; 11) and a perovskite layer (9);
- an interface between a charge-carrier selective layer with a thickness less than 5nm (7; 11) and an electrode layer (5; 13).

14. Method of preventing electrical shunts in a perovskite-based optoelectronic device (1) comprising a self-assembled monolayer charge-carrier selective layer (7; 11) in direct contact with an electrode layer (5; 13), said method comprising a step of depositing insulating nanoparticles (8) having a diameter between 10 nm and 100 nm directly on at least one of:
- a charge-carrier selective layer with a thickness less than 5nm (7) upon which a perovskite layer (9) is subsequently deposited;
- a perovskite layer (9) upon which a charge-carrier selective layer with a thickness less than 5nm (11) is subsequently deposited;
- a charge-carrier selective layer with a thickness less than 5nm (11) upon which an electrode layer (13) is subsequently deposited;
- an electrode layer (5) upon which a charge-carrier selective layer with a thickness less than 5nm (7) is subsequently deposited.
